# EUROPÄISCHE PATENTSCHRIFT

(11) **EP 0 809 879 B1**
(45) Veröffentlichungstag und Bekanntmachung des Hinweises auf die Patenterteilung: **29.07.1998**
(21) Anmeldenummer: 96900858.0
(22) Anmeldetag: 26.01.1996
(51) Int. Cl.: H02M 1/12, H02J 3/01

(54) **VERFAHREN UND VORRICHTUNG ZUM FILTERN UND BEDÄMPFEN VON DURCH ENDVERBRAUCHER VERURSACHTE LEITUNGSGEBUNDENE STÖRUNGEN**
METHOD AND DEVICE FOR FILTERING AND DAMPING CONDUCTED INTERFERENCE CAUSED BY ULTIMATE CONSUMERS
PROCEDE ET DISPOSITIF POUR FILTRER ET AMORTIR DES INTERFERENCES GUIDEES PROVOQUEES PAR DES CONSOMMATEURS TERMINAUX

(30) Priorität: 08.02.1995 DE 19504125
(43) Veröffentlichungstag der Anmeldung: 03.12.1997
(73) Patentinhaber: SIEMENS AKTIENGESELLSCHAFT, 80333 München (DE)
(72) Erfinder: IMRICH, Franz, D-91058 Erlangen (DE); SEGGER,Bernd, 91052 Erlangen (DE)
(86) Internationale Anmeldenummer: DE9600113
(87) Internationale Veröffentlichungsnummer: WO9624983

(56) Entgegenhaltungen:
- EP-A- 0 186 524
- US-A- 3 996 537
- US-A- 4 967 334

## Beschreibung

Die Erfindung bezieht sich auf ein Verfahren sowie eine Vorrichtung zum Filtern und Bedämpfen von durch Endverbraucher, insbesondere Transistorpulsumrichter, verursachte leitungsgebundene Störungen, die in Versorgungsnetze, insbesondere Drei-Phasen-Netze, rückwirken, wobei mehrere unterschiedliche Filterstufen hintereinander geschaltet werden.

Elektromagnetische Verträglichkeit, kurz EMV ist ein Thema, das in der elektrotechnischen Industrie eine immer größere Rolle spielt. Durch die europaweite Harmonisierung innerhalb der Europäischen Union wird bis spätestens 01.01.1996 die Einhaltung entsprechender EMV-Normen gefordert. Darunter befindet sich auch die EN55011 für leitungsgebundene Störungen und Störabstrahlung. Unter EMV ist die Eigenschaft eines Gerätes zu verstehen, in einer elektromagnetischen Umgebung befriedigend zu funktionieren, ohne selbst mit unzulässig starken elektromagnetischen Störungen die Umwelt zu belasten. Mit anderen Worten: Elektrotechnische Geräte sollen nicht nur gegen Störungen immun sein, es soll auch verhindert werden, daß sie selbst Störungen aussenden. Dies trifft auch und vor allem auf elektrische Antriebe zu, welche in der Regel Störsignale erzeugen, die in das den elektrischen Antrieb versorgende Versorgungsnetz rückwirken können. Im Zuge der Umsetzung der EMV-Normen wird nun die Anforderung gestellt, daß elektrische Endverbraucher wie beispielsweise elektrische Antriebe, welche durch Transistorpulsumrichter gesteuert werden, so betrieben werden, daß ihre Störaussendung unter den durch die Norm geforderten Grenzwerten liegt. Um diese Norm einhalten zu können, ist es notwendig, eine Filtereinheit vor die Geräte anzubringen. Eine solche Filtereinheit muß zur Erfüllung der Norm leitungsgebundene Störungen im Bereich von 150 kHz bis 30 MHz bedämpfen.

Diese Problem konnte mit bisherigen Filteraufbauten wie beispielsweise einem Netzfilter für Drei-Phasen-Systeme (siehe dazu Siemens Mathushita Components GmbH & Co. KG, Marketingunterlagen, Seite 299, Schaltbild, Bestell-Nr. B84299/K28) nicht gelöst werden, da die Störungen, welche beispielsweise direkt am Netz getaktete Transistorpulsumrichter erzeugen, zu energiereich für diese Entstörfilter waren. Wollte man solche großen Energien mit herkömmlichen Störfiltern verarbeiten, so hätte dies zur Folge, daß bestimmte Bauteile, wie etwa eine verwendete stromkompensierte Drossel oder ein Leistungskondensator, derart groß dimensioniert werden müßte, daß eine Fertigung eines solchen Filters unwirtschaftlich wird.

Weiterhin ist es bekannt, zur Entstörung von elektrischen Endverbrauchern Drosseln sowie RC-Glieder einzusetzen, welche beispielsweise bei Einsatz in einem Drei-Phasen-System in Sternschaltung und Dreieckschaltung vorkommen (siehe dazu ebenfalls im vorherigen Absatz genanntes beispielhaftes Filter mit entsprechender Quellenangabe). Jedoch entsteht auch hierbei das Problem, daß diese Bauteilkombination in der Regel nur für geringere als die geforderten Leistungen und Energien dimensioniert werden können bzw. eine Konstruktion von entsprechend ausgelegten Bauteilen Probleme hinsichtlich der dadurch entstehenden Kosten und der Dimension solcher Bauteile hervorruft. Zwar ist aus obiger Quelle weiterhin bekannt, mit den genannten Bauteilen mehrere aufeinanderfolgende Filterstufen aufzubauen, jedoch sind die dadurch durch herkömmliche Entstörfilter erzielten Ergebnisse im Hinblick auf die durch die Norm geforderten Grenzwerte unbefriedigend.

Aus der US-A-3996537 ist eine einphasige Filteranordnung bekannt, die aus Kapazitäten, Induktivitäten und stromkompensierte Drosseln besteht und symmetrische und asymmetrische Störungen ausfiltert.

Der Erfindung liegt daher die Aufgabe zugrunde, ein Verfahren sowie eine zugehörige Vorrichtung der eingangs genannten Art so auszubilden, daß die durch die EMV-Norm EN55011 geforderten Grenzwerte für leitungsgebundene Störungen im Bereich von 150 kHz bis etwa 30 MHz in diesem Spektrum eingehalten werden, daß diese auch für energiereiche Endverbraucher wie beispielsweise Transistorpulsumrichter eingehalten werden, daß die dazu notwendigen elektrischen Bauteile so angeordnet werden, daß preiswerte Standardbauteile herkömmlicher Bauart eingesetzt werden können und auf die Konstruktion speziell für die hohen Energien ausgelegter Bauteile verzichtet werden kann.

Gemäß der Erfindung wird diese Aufgabe durch folgende Merkmale gelöst:
- 1.1: vom Eingang des Endverbrauchers rückschreitend hin zum Ausgang des Versorgungsnetzes wird in einer ersten Filterstufe je eine Kommutierungsdrossel in jede Leistungsphase geschaltet und werden nach jeder Drossel durch Sternschaltung je eines Kondensators gegen Erdpotential asymmetrische Störungen sowie durch Dreieckschaltung je eines Kondensators mit in Reihe geschaltetem Dämpfungswiderstand zwischen die einzelnen Phasen symmetrische Störungen ausgefiltert,
- 1.2: in einer darauffolgenden Filterstufe wird durch je eine in jede Leistungsphase geschaltete Vorschaltdrossel eine Abkopplung vom Versorgungsnetz vorgenommen,
- 1.3: für eine letzte Filterstufe erfolgt durch jeweils einen in Form einer Sternschaltung gegen Erdpotential geschalteten Kondensator und darauffolgende in jede Leitungsphase eingesetzte stromkompensierte Drosseln mit gemeinsamem Ringkern eine Feinfilterung asymmetrischer Störungen.

Eine erste vorteilhafte Ausgestaltung des erfindungsgemäßen Verfahrens zeichnet sich dadurch aus, daß die durch die deutsche Norm VDE 0160 geforderte Entladung von Ableitkondensatoren innerhalb von 5 Sekunden auf einen Spannungswert von 16 V erfüllt wird. Dies wird durch folgendes Merkmal erreicht:
- 2.1: parallel zu den Kondensatoren in Sternschaltung der ersten Filterstufe werden Ableitwiderstände geschaltet.

In einer weiteren vorteilhaften Ausgestaltung der vorliegenden Erfindung wird erreicht, daß durch den Einsatz der Vorschaltdrosseln neben der Abkopplung vom Versorgungsnetz gleichzeitig eine symmetrische Entstörung stattfindet. Diese ist gekennzeichnet durch folgendes Merkmal:
- 3.1: als Vorschaltdrosseln werden solche mit einem Luftspalt, beispielsweise durch Verwendung eines geschenkelten Ferritkerns, verwendet.

In einer weiteren vorteilhaften Ausgestaltung der vorliegenden Erfindung wird erreicht, daß trotz der Verarbeitung von Störungen energiereicher Endverbraucher eine kleine Dimensionierung der Filtereinheit möglich ist. Dieses ist durch folgendes Merkmal gekennzeichnet:
- 4.1: als Kommutierungsdrosseln werden Hochfrequenz-Kommutierungsdrosseln verwendet, welche hohe Ströme verarbeiten, ohne in Sättigung zu gehen.

Als besonders günstig haben sich sogenannte COROVAC®-Kommutierungsdrosseln erwiesen, die aus einem gesinterten Metallpulver bestehen und dadurch auch bei hohen Strömen nicht so schnell in Sättigung geraten.

Gemäß der Erfindung wird ferner eine Vorrichtung zur Verfahrensdurchführung geschaffen, die besonders kostengünstig realisiert werden kann, welche durch energiereiche Endverbraucher verursachte Störung filtert und aufgrund einer vorteilhaften Anordnung von Einzelkomponenten deren besonders effektive Arbeitsweise ermöglicht. Diese Vorrichtung ist gekennzeichnet durch folgende Merkmale:
- 5.1: vor den Eingang des Endverbrauchers ist je eine Kommutierungsdrossel in jede Leistungsphase geschaltet und nach jeder Drossel in Form einer Sternschaltung je ein Kondensator gegen Erdpotential sowie in Form einer Dreieckschaltung je ein Kondensator mit in Reihe geschaltetem Dämpfungswiderstand zwischen die einzelnen Phasen geschaltet,
- 5.2: davor ist je eine Vorschaltdrossel in jede Leistungsphase geschaltet,
- 5.3: davor ist jeweils ein in Form einer Sternschaltung gegen Erdpotential geschalteter Kondensator sowie darauffolgend in jede Leistungsphase je eine stromkompensierte Drossel mit gemeinsamem Ringkern geschaltet.

In einer ersten vorteilhaften Ausgestaltung der erfindungsgemäßen Vorrichtung wird die deutsche Norm VDE 0160 erfüllt, indem sie folgendes Merkmal aufweist:
- 6.1: parallel zu den Kondensatoren in Sternschaltung der ersten Filterstufe sind Ableitwiderstände geschaltet.

Eine weitere vorteilhafte Ausgestaltung der erfindungsgemäßen Vorrichtung ermöglicht neben einer Abkopplung vom Netz eine gleichzeitige Filterung symmetrischer Störsignale, indem sie folgendes Merkmal aufweist:
- 7.1: als Vorschaltdrosseln sind solche mit einem Luftspalt, beispielsweise mit geschenkeltem Ferritkern, eingesetzt.

Eine weitere vorteilhafte Ausgestaltung der erfindungsgemäßen Vorrichtung ist dadurch gekennzeichnet, daß deren Dimensionierung besonders klein erfolgen kann und weiterhin die erforderlichen energiereichen Störsignale verarbeitet werden können. Diese ist gekennzeichnet durch folgendes Merkmal:
- 8.1: als Kommutierungsdrosseln sind Hochfrequenz-Kommutierungsdrosseln, insbesondere sogenannte COROVAC-Kommutierungsdrosseln eingebaut, welche hohe Ströme verarbeiten, ohne in Sättigung zu gehen.

Die mit der Erfindung erzielten Vorteile bestehen insbesondere darin, daß besonders energiereiche elektrische Endverbraucher unter Einhaltung der einschlägigen EMV-Normen an beliebige Versorgungsnetze angeschlossen werden können, ohne daß durch den jeweiligen Endverbraucher erzeugte leitungsgebundene Störungen auf das jeweilige Versorgungsnetz rückwirken. Dabei werden preisgünstige, herkömmliche Standardbauelemente eingesetzt, welche besonders vorteilhaft angeordnet werden, so daß die Notwendigkeit einer Konstruktion speziell auf die zu verarbeitenden hohen Energien von Störsignalen zugeschnittener teuerer Bauelemente vermieden werden kann. Darüber hinaus werden die herkömmlichen, preisgünstigen Bauelemente so vorteilhaft angeordnet, daß das erfindungsgemäße Verfahren bzw. die erfindungsgemäße Vorrichtung besonders preisgünstig realisiert werden kann. Durch eine besonders vorteilhafte Anordnung der Bauteile in mehreren Stufen wird erreicht, daß diese besonders effektiv zusammen arbeiten.

Ein Ausführungsbeispiel der Erfindung ist in der Zeichnung dargestellt und wird im folgenden näher erläutert. Dabei zeigt:

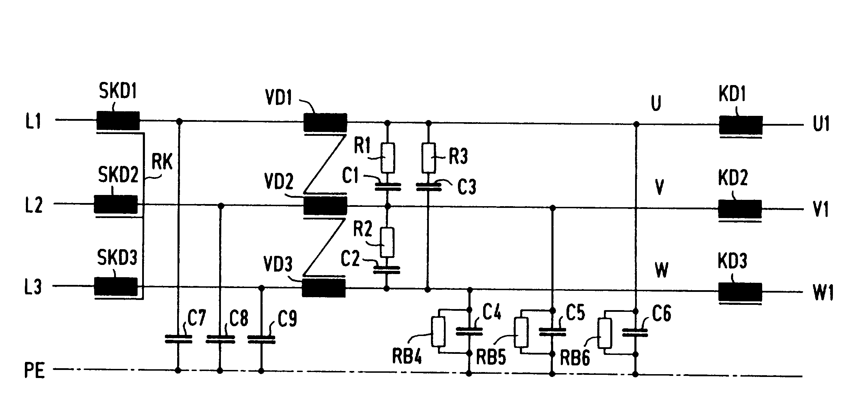

- FIG 1: Schaltbild eines Entstörfilters für leitungsgebundene Störungen in einem Drei-Phasen-Versorgungsnetz.

In der Darstellung gemäß FIG 1 ist ein Schaltbild gezeigt, welches ein mögliches Ausführungsbeispiel der erfindungsgemäßen Vorrichtung zum Filtern und Bedämpfen von durch Endverbraucher, insbesondere Transistorpulsumrichter verursachende leitungsgebundene Störungen anhand des Einsatzes in einem Drei-Phasen-Versorgungsnetz zeigt. Dabei stellen die drei Leiter L1, L2 und L3 das Versorgungsnetz dar, die Anschlüsse U1, V1 und W1 die Ausgänge des Entstörfilters, die mit dem jeweils zu entstörenden Endverbraucher verbunden sind. Eine Schiene mit Erdpotential PE ist in Form einer strichpunktierten Linie dargestellt. Ausgehend vom Endverbraucher sind in die einzelnen Leistungsphasen U1, V1 und W1 jeweils einphasige Hochfrequenz-Kommutierungsdrosseln KD1, KD2 und KD3 in Reihe geschaltet. Daran anschließend sind jeweils in Form einer Sternschaltung Kondensatoren C4, C5 und C6 mit jeweils parallel geschalteten Ableitwiderständen RB4, RB5 und RB6 gegen Erdpotential PE geschaltet. Darauffolgend sind in Form einer Dreieckschaltung jeweils Kondensatoren C1, C2 und C3 mit jeweils in Reihe davor geschalteten Dämpfungswiderständen R1, R2 und R3 zwischen die einzelnen Leistungsphasen U, V und W geschaltet. Daran anschließend sind jeweils Vorschaltdrosseln mit Luftspalt VD1, VD2 und VD3, welche über einen geschenkelten Kern gewickelt sind, in Reihe in die Leistungsphasen geschaltet. Darauffolgend sind jeweils in Form einer Sternschaltung Kondensatoren C7, C8 und C9 gegen Erdpotential PE geschaltet. Daran anschließend folgen in Reihe in die Leistungsphasen geschaltet jeweils stromkompensierte Drosseln SKD1, SKD2 und SKD3, welche über einen gemeinsamen Ringkern RK gewickelt sind.

Zur Realisierung eines Entstörfilters gemäß der vorliegenden Erfindung werden in einem vorteilhaften Ausführungsbeispiel Hochfrequenz-Kommutierungsdrosseln KD1, KD2, KD3 in die Leistungsphasen geschaltet. Für die Hochfrequenz-Kommutierungsdrosseln werden vorteilhafterweise sogenannte COROVAC®-Drosseln verwendet, welche sich dadurch auszeichnen, daß sie aufgrund eines Kernes, welcher aus einem speziellen gesinterten Metallpulver besteht, auch hohe Ströme verarbeiten können, ohne daß das verwendete Material in Sättigung geht. Legt man für das Ausführungsbeispiel als Endverbraucher einen Transistorpulsumrichter zugrunde, so haben die Hochfrequenz-Kommutierungsdrosseln zur Folge, daß sich in ihnen, dadurch daß sie durch den Umrichter kurzgeschlossen werden, ein Magnetfeld aufbaut, welches schließlich zusammenbricht und so die hohe erforderliche Energie liefert. Die Hochfrequenz-Kommutierungsdrosseln sind bis ca. 600 kHz induktiv und leisten eine symmetrische Entstörung, also Entstörung zwischen den einzelnen Phasen, sowie gleichzeitig eine asymmetrische Entstörung, worunter Störungen zwischen einer einzelnen Phase und dem Erdpotential PE verstanden werden. Die Hochfrequenz-Kommutierungsdrosseln bilden weiterhin zusammen mit den in Form einer Sternschaltung geschalteten Ableitkapazitäten C4, C5 und C6 ein sehr wirksames Filter gegen asymmetrische Störungen im Bereich von ca. 2 bis 3 MHz. Zur Einhaltung der in der deutschen Norm VDE0160 geforderten Entladung der Ableitkapazitäten innerhalb von 5 Sekunden auf einen Wert von 60 V sind parallel zu den Ableitkapazitäten C4, C5 und C6 Ableitwiderstände RB4, RB5 und RB6 geschaltet. Zusammen mit der in Form einer Dreieckschaltung angeordneten Kapazität C1, C2 und C3 bilden die Hochfrequenz-Kommutierungsdrosseln ein Filter gegen symmetrische Störungen zwischen den einzelnen Leistungsphasen U, V und W. Da die einzelnen Hochfrequenz-Kommutierungsdrosseln KD1, KD2 und KD3 zusammen mit den Kapazitäten C1, C2 und C3 sogenannte L-C-Schwingkreise bilden, welche unerwünschter Maßen in Schwingungen geraden können, sind in Reihe zu den einzelnen Kapazitäten Dämpfungswiderstände R1, R2 und R3 geschaltet, welche ein Schwingen des Filters für symmetrische Störungen verhindern. Durch diese RC-Kombinationen und die Ableitkondensatoren C4, C5 und C6 gegen Potential Erde PE werden die Netzstörungen im Störbereich wirksam gedämpft.

In einer weiteren Filterstufe werden anschließend die noch verbliebenen wenig energiereichen Störungen gedämpft. Dazu werden in der jeweiligen Leitungsphase Vorschaltdrosseln mit Luftspalt VD1, VD2 und VD3 in Reihe geschaltet, welche beispielsweise über einen geschenkelten Kern gewickelt sind. Da sich aufgrund dieser speziellen Wicklung die Magnetfelder, welche auf den Signalen zwischen Phase und Erdpotential PE beruhen, gegenseitig aufheben, besitzen die Vorschaltdrosseln VD1, VD2 und VD3 eine Filterwirkung für symmetrische Störung, also solche Störungen, die zwischen einzelnen Leistungsphasen auftreten, indem sie die nach wie vor vorhandenen Störspannungen nach Art eines Spannungsteilers herunterteilen. Gleichzeitig wird durch die Vorschaltdrosseln eine Abkopplung vom Versorgungsnetz erreicht, dadurch, daß Rückwirkungen der in den Kondensatoren C1, C2 und C3 enthaltenen, aufgrund der hohen Energien teilweise erheblichen Ladungen, verhindert werden.

Auf die Vorschaltdrosseln folgend werden in einer weiteren Filterstufe zur Feinentstörung der verbliebenen kleinen Ströme Kondensatoren C7, C8 und C9 zwischen den einzelnen Leistungsphasen und dem Erdpotential PE in Form einer Sternschaltung geschaltet. Diese bilden in Verbindung mit den Vorschaltdrosseln VD1, VD2 und VD3 eine Filterstufe für ca. 8 bis 30 MHz. Da Kapazitäten, die Signale in diesem Störbereich wirksam filtern können, in der Regel eine hohe Qualität erfordern, welche lediglich bei klein dimensionierten herkömmlichen Bauteilen preiswert verfügbar ist, wurden die energiereichen Störsignale in den beiden vorhergehenden Filterstufen auf ein Niveau heruntergeführt, welches es ermöglicht, solche genannte preiswerte Standardbauteile mit ausreichenden geforderten Qualitäten einzusetzen. Auf diese Art und Weise wird verhindert, daß teuere Spezialkondensatoren für hohe Energien ausgelegt werden müssen, die gleichzeitig die geforderte Qualität aufweisen, was mit erheblichen Kosten verbunden ist und zusätzlich sehr groß dimensionierte Bauteile erfordern würde. Diese Kapazitäten C7, C8 und C9 wirken ihrerseits wiederum zusammen mit stromkompensierten Drosseln SKD1, SKD2 und SKD3. Diese sind im Anschluß an die Kapazitäten in Reihe in die Leitungsphasen direkt an das Versorgungsnetz angeschaltet. Die genannten Drosseln sind auf einen gemeinsamen Ferritkern gewickelt, für welchen das Ferritmaterial der Bezeichnung N30 ausreichend ist. Die Verwendung eines gemeinsamen Ringkernes hat bei den verbleibenden zu verarbeitenden kleinen Störströmen keine Probleme mehr mit der auftretenden Sättigung zur Folge. Aufgrund des gemeinsamen Ringkernes RK heben sich jedoch die Magnetfelder, die durch die zwischen den einzelnen Leistungsphasen fließenden Ströme aufgebaut werden, gegenseitig auf. Dies hat zur Folge, daß nur die Magnetfelder von zwischen den einzelnen Leitungsphasen und Erdpotential PE fließenden Strömen gefiltert werden können. Somit haben die stromkompensierten Drosseln in Verbindung mit den Kapazitäten C7, C8 und C9, mit denen sie sogenannte L-C-Glieder bilden, eine Ableitung asymmetrischer Störungen zur Folge. Ein durch das Zusammenwirken der Vorschaltdrosseln VD1, VD2 und VD3 in Verbindung mit den Kapazitäten C7, C8 und C9 bedingtes Nachlassen der Dämpfung bei ca. 150 kHz wird durch den Ringkern in Verbindung mit der Netzinduktivität des Versorgungsnetzes ausgeglichen.

Für die Verwendung des in dem dargestellten Ausführungsbeispiel erläuterten Entstörfilters in Verbindung mit einem Transistorpulsumrichter ergibt sich für die einzelnen Bauteile folgende vorteilhafte Bemessung. Die Dämpfungswiderstände R1, R2 und R3 besitzen einen Wert von 1,2 ohm bei einer Leistung von 200 W. Die Ableitwiderstände RB4, RB5 und RB6 weisen einen Wert von 22 kohm auf und erfordern eine Leistung von 13 W. Die dazugehörigen Kapazitäten C1, C2 und C3 sind vorteilhafterweise MKV-Kondensatoren mit einer Kapazität von 0,033 mF und einer Durchschlagsfestigkeit von 460 V. Die Ableitkondensatoren C4, C5 und C6 sind ebenfalls MKV-Kondensatoren mit einer Durchlagsfestigkeit von 460 V, besitzen jedoch eine Kapazität von 0,015 mF. Die zwischen stromkompensierten Drosseln und Vorschaltdrosseln in Form einer Sternschaltung angeordneten Kapazitäten 7, 8 und 9 müssen nur noch geringe Leistungen verarbeiten, weshalb für sie Standardbauteile geringer Leistung verwendet werden können. Die Kapazität der Kondensatoren beträgt vorteilhafterweise 68 nF. Die Werte der einzelnen Drosseln, stromkompensierte Drosseln, Vorschaltdrosseln mit Luftspalt und Hochfrequenz-Kommutierungsdrosseln, richten sich nach der Leistung des jeweils verwendeten Transistorpulsumrichters.

Neben dem gezeigten Ausführungsbeispiel zum Einsatz in einem Drei-Phasen-Versorgungsnetz läßt sich das erfindungsgemäße Verfahren bzw. die erfindungsgemäße Vorrichtung zur Entstörung von leitungsgebundenen Entstörungen auch in herkömmlichen Wechselstromnetzen mit zwei Phasen einsetzen. Anstelle der Stern- bzw. Dreieckschaltungen werden dazu Schaltungen zwischen den zwei Phasen gegenüber Erdpotential PE bzw. zwischen den beiden Phasen vorgenommen.

## Patentansprüche

1. Verfahren zum Filtern und Bedämpfen von durch Endverbraucher, insbesondere Transistorpulsumrichter, verursachte leitungsgebundene Störungen, die in dreiphasige Versorgungsnetze dreiphasige rückwirken, wobei mehrere unterschiedliche Filterstufen hintereinander geschaltet werden, **gekennzeichnet** durch folgende Merkmale:
1.1 vom Eingang des Endverbrauchers (U1,V1,W1) rückschreitend hin zum Ausgang des Versorgungsnetzes (L1,L2,L3) wird in einer ersten Filterstufe je eine **einphasige** Kommutierungsdrossel (KD1,KD2,KD3) in jede Leistungsphase geschaltet und werden nach jeder Drossel durch Sternschaltung je eines Kondensators (C4,C5,C6) gegen Erdpotential (PE) asymmetrische Störungen sowie durch Dreieckschaltung je eines Kondensators (C1,C2,C3) mit in Reihe geschaltetem Dämpfungswiderstand (R1,R2,R3) zwischen die einzelnen Phasen symmetrische Störungen ausgefiltert,
1.2 in einer darauffolgenden Filterstufe wird durch je eine in jede Leistungsphase **dreiphasig verschaltete** Vorschaltdrossel (VD1, VD2,VD3) eine Abkopplung vom Versorgungsnetz vorgenommen,
1.3 für eine letzte Filterstufe erfolgt durch jeweils einen in Form einer Sternschaltung gegen Erdpotential (PE) geschalteten Kondensator (C7,C8,C9) und darauffolgende in jede Leitungsphase eingesetzte stromkompensierte Drosseln (SKD1,SKD2,SKD3) mit gemeinsamem Ringkern (RK) eine Feinfilterung asymmetrischer Störungen.

2. Verfahren nach Anspruch 1, **gekennzeichnet** durch folgendes Merkmal:
2.1 parallel zu den Kondensatoren in Sternschaltung (C4,C5, C6) der ersten Filterstufe werden Ableitwiderstände (RB4,RB5,RB6) geschaltet.

3. Verfahren nach Anspruch 1 oder 2, **gekennzeichnet** durch folgendes Merkmal:
3.1 als Vorschaltdrosseln (VD1, VD2, VD3) werden solche mit einem Luftspalt, beispielsweise durch Verwendung eines geschenkelten Ferritkerns, verwendet.

4. Verfahren nach Anspruch 1, 2 oder 3, **gekennzeichnet** durch folgendes Merkmal:
4.1 als Kommutierungsdrosseln (KD1, KD2, KD3) werden Hochfrequenz-Kommutierungsdrosseln, insbesondere sogenannte COROVAC-Kommutierungsdrosseln verwendet, welche hohe Ströme verarbeiten, ohne in Sättigung zu gehen.

5. Vorrichtung zum Filtern und Bedämpfen von durch Endverbraucher, insbesondere Transistorpulsumrichter, verursachte leitungsgebundene Störungen, die in dreiphasige Versorgungsnetze dreiphasige rückwirken, wobei mehrere unterschiedliche Filterstufen hintereinander geschaltet sind, **gekennzeichnet** durch folgendes Merkmal:
5.1 vor den Eingang des Endverbrauchers ist je eine **einphasige** Kommutierungsdrossel (KD1,KD2,KD3) in jede Leistungsphase (U1,V1,W1) geschaltet und nach jeder Drossel in Form einer Sternschaltung je ein Kondensator (C4,C5,C6) gegen Erdpotential (PE) sowie in Form einer Dreieckschaltung je ein Kondensator (C1,C2,C3) mit in Reihe geschaltetem Dämpfungswiderstand (R1,R2,R3) zwischen die einzelnen Phasen geschaltet,
5.2 davor ist je eine Vorschaltdrossel (VD1,VD2,VD3) in jeder Leistungsphase **dreiphasig verschaltet angeordnet**,
5.3 davor ist jeweils ein in Form einer Sternschaltung gegen Erdpotential (PE) geschalteter Kondensator (C7,C8,C9) sowie darauffolgend in jede Leitungsphase je eine stromkompensierte Drossel (SKD1,SKD2,SKD3) mit gemeinsamem Ringkern (RK) geschaltet.

6. Vorrichtung nach Anspruch 5, **gekennzeichnet** durch folgendes Merkmal:
6.1 parallel zu den Kondensatoren ( C4,C5,C6) in Sternschaltung der ersten Filterstufe sind Ableitwiderstände (RB4, RB5,RB6) geschaltet.

7. Vorrichtung nach Anspruch 5 oder 6, **gekennzeichnet** durch folgendes Merkmal:
7.1 als Vorschaltdrosseln (VD1,VD2,VD3) sind solche mit einem Luftspalt, beispielsweise mit geschenkeltem Ferritkern, eingesetzt.

8. Vorrichtung nach Anspruch 5, 6 oder 7, **gekennzeichnet** durch folgendes Merkmal:
8.1 als Kommutierungsdrosseln (KD1,KD2,KD3) sind Hochfrequenz-Kommutierungsdrosseln eingebaut, welche hohe Ströme verarbeiten, ohne in Sättigung zu gehen.

## Claims

1. Method for filtering and damping conducted interference which is caused by ultimate consumers, in particular transistor pulse converters, and which retroacts in three-phase supply networks, wherein a plurality of different three-phase filter stages are connected in series, characterised by the following features:
1.1. working back from the input of the ultimate consumer (U1, V1, W1) as far as the output of the supply network (L1, L2, L3), in a first filter stage a respective single-phase commutation inductor (KD1, KD2, KD3) is connected into each power phase and after each inductor asymmetrical interference is filtered out by means of a star circuit arrangement of a respective capacitor (C4, C5, C6) to earth potential (PE) and in addition symmetrical interference is filtered out by means of a delta circuit arrangement of a respective capacitor (C1, C2, C3) with a series-connected damping resistor (R1, R2, R3) between the individual phases;
1.2 uncoupling from the supply network is effected in a subsequent filter stage by means of a respective series inductor (VD1, VD2, VD3) connected into each power phase in a three-phase manner;
1.3 for a final filter stage, fine filtering of asymmetrical interference is effected by means of a respective capacitor (C7, C8, C9) connected in the form of a star circuit arrangement to earth potential (PE) and subsequent current-compensated inductors (SKD1, SKD2, SKD3) inserted into each power phase and having a common annular core (RK).

2. Method according to claim 1, characterised by the following feature:
2.1 discharge resistors (RB4, RB5, RB6) are connected in parallel with the capacitors in the star circuit arrangement (C4, C5, C6) of the first filter stage.

3. Method according to claim 1 or 2,
characterised by the following feature:
3.1 those series inductors that have an air gap, for example as a result of the use of a limbed ferrite core, are used as series inductors (VD1, VD2, VD3).

4. Method according to claim 1, 2 or 3,
characterised by the following feature:
4.1 high-frequency commutation inductors, in particular so-called COROVAC commutation inductors, which process high currents without entering the state of saturation, are used as commutation inductors (KD1, KD2, KD3).

5. Device for filtering and damping conducted interference which is caused by ultimate consumers, in particular transistor pulse converters, and which retroacts in three-phase supply networks, wherein a plurality of different three-phase filter stages are connected in series, characterised by the following feature:
5.1 before the input of the ultimate consumer a respective single-phase commutation inductor (KD1, KD2, KD3) is connected into each power phase (U1, V1, W1) and after each inductor in the form of a star circuit arrangement a respective capacitor (C4, C5, C6) is connected to earth potential (PE) and in addition in the form of a delta circuit arrangement a respective capacitor (C1, C2, C3) with a series-connected damping resistor (R1, R2, R3) is connected between the individual phases;
5.2 arranged before this there is a respective series inductor (VD1, VD2, VD3) connected into each power phase in a three-phase manner;
5.3 connected before this there is a respective capacitor (C7, C8, C9) connected in the form of a star circuit arrangement to earth potential (PE) and in addition following this connected into each power phase there is a respective current-compensated inductor (SKD1, SKD2, SKD3), the latter having a common annular core (RK).

6. Device according to claim 5, characterised by the following feature:
6.1 discharge resistors (RB4, RB5, RB6) are connected in parallel with the capacitors (C4, C5, C6) in the star circuit arrangement of the first filter stage.

7. Device according to claim 5 or 6,
characterised by the following feature:
7.1 those series inductors that have an air gap, for example having a limbed ferrite core, are used as series inductors (VD1, VD2, VD3).

8. Device according to claim 5, 6 or 7,
characterised by the following feature:
8.1 high-frequency commutation inductors, which process high currents without entering the state of saturation, are installed as commutation inductors (KD1, KD2, KD3).

## Revendications

1. Procédé de filtrage et d'amortissement de parasites liés aux lignes et provoqués par des consommateurs terminaux, notamment par des convertisseurs d'impulsions transistorisés, qui se répercutent dans des réseaux d'alimentation triphasés, plusieurs étages de filtrage triphasés de types différents étant montés les uns derrière les autres, caractérisé par les particularités suivantes :
1.1 à partir de l'entrée du consommateur terminal (U1, V1, W1) et en remontant vers la sortie du réseau d'alimentation (L1, L2, L3), il est monté, dans un premier étage de filtrage, une self de commutation monophasée (KD1, KD2, KD3) est branchée dans un premier étage de filtrage dans chaque phase, et il est filtré des parasites disymétriques après chaque self par le montage en étoile d'un condensateur (C4, C5, C6) par rapport au potentiel de terre (PE), ainsi que des parasites symétriques entre les phases par le montage en triangle d'un condensateur (C1, C2, C3) avec une résistance d'amortissement (R1, R2, R3) montée en série,
1.2 dans un étage de filtrage suivant, on procède à un découplage du réseau d'alimentation par l'intermédiaire d'une self inductive supplémentaire (VD1, VD2, VD3) branchée en triphasé dans chaque phase,
1.3 un filtrage fin de parasites disymétriques est effectué dans un dernier étage de filtrage par un condensateur (C7, C8, C9) qui est à chaque fois branché sous la forme d'un montage en étoile par rapport au potentiel de terre (PE), et de selfs suivantes (SKD1, SKD2, SKD3) compensées en courant, qui comportent un noyau toroïdal commun (RK) et qui sont insérées dans chaque phase.

2. Procédé selon la revendication 1, caractérisé par la particularité suivante :
2.1 des résistances de dérivation (RB4, RB5, RB6) sont montées en parallèle aux condensateurs (C4, C5, C6) montés en étoile du premier étage de filtrage.

3. Procédé selon la revendicaticn 1 ou 2, caractérisé par la particularité suivante :
3.1 des selfs ayant un entrefer sont utilisées en tant que selfs inductives supplémentaires (VD1, VD2, VD3), par exemple par l'utilisation d'un noyau de ferrite avec des branches.

4. Procédé selon l'une des revendications 1, 2 ou 3, caractérisé par la particularité suivante :
4.1 on utilise en tant que selfs de commutation (KD1, KD2, KD3) ) des selfs de commutation haute fréquence, notamment des selfs de commutation dites COROVAC® qui traitent des courants élevés sans arriver à saturation.

5. Dispositif de filtrage et d'amortissement de parasites liés aux lignes provoqués par des consommateurs terminaux, notamment par des convertisseurs d'impulsions transistorisés, qui se répercutent dans des réseaux d'alimentation triphasés, plusieurs étages de filtrage triphasés de types différents étant montés les uns derrière les autres, caractérisé par les particularités suivantes :
5.1 une self de commutation monophasée (KD1, KD2, KD3) est montée dans chaque phase (U1, V1, W1) du côté amont de l'entrée du consommateur terminal, et du côté aval de chaque self, il est monté, sous la forme d'un montage en étoile, un condensateur (C4, C5, C6) par rapport au potentiel de terre (PE), ainsi que, sous la forme d'un couplage en triangle, entre les phases, un condensateur (C1, C2, C3) ayant une résistance d'amortissement (R1, R2, R3) en série,
5.2 du côté amont, une self inductive supplémentaire (VD1, VD2, VD3) est montée en triphasé dans chaque phase,
5.3 du côté amont, (C7, C8, C9) il est monté, sous la forme d'un montage en étoile, un condensateur par rapport au potentiel de terre (PE), suivi dans chaque phase d'une self (SKD1, SKD2, SKD3) compensée en courant et comportant un noyau toroïdal commun (RK).

6. Dispositif selon la revendication 5, caractérisé par la particularité suivante :
6.1 des résistances de dérivation (RB4, RB5, RB6) sont montées en parallèle aux condensateurs (C4, C5, C6) montés en étoile du premier étage de filtrage.

7. Dispositif selon la revendication 5 ou 6, caractérisé la particularité suivante :
7.1 il est utilisé, en tant que selfs inductives (VD1, VD2, VD3) supplémentaires, des selfs ayant un entrefer qui comportent par exemple un noyau de ferrite avec des branches.

8. Dispositif selon la revendication 5, 6 ou 7, caractérisé par la particularité suivante :
8.1 des selfs de commutation haute fréquence sont utilisées en tant que selfs de commutaticn (KD1, KD2, KD3), qui traitent des courants élevés sans arriver à saturation.
